(19) Europäisches Patentamt
European Patent Office
Office européen des brevets

(11) **EP 1 243 935 A1**

(12) **DEMANDE DE BREVET EUROPEEN**

(43) Date de publication:
**25.09.2002 Bulletin 2002/39**

(51) Int Cl.⁷: $G01R\ 31/36$

(21) Numéro de dépôt: **02290298.5**

(22) Date de dépôt: **07.02.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **19.03.2001 FR 0103679**

(71) Demandeur: **ALCATEL**
**75008 Paris (FR)**

(72) Inventeur: **Berlureau, Thierry**
**33300 Bordeaux (FR)**

(74) Mandataire: **Sciaux, Edmond et al**
**COMPAGNIE FINANCIERE ALCATEL**
**Dépt. Propr. Industrielle,**
**30, avenue Kléber**
**75116 Paris (FR)**

Remarques:
Une requête en rectification ...... a été présentée conformément à la règle 88 CBE. Il est statué sur cette requête au cours de la procédure engagée devant la division d'examen (Directives relatives à l'examen pratiqué à l'OEB, A-V, 3.).

(54) **Procédé de contrôle de la décharge d'une batterie de générateurs électrochimiques secondaires**

(57) La présente invention a pour objet un procédé de contrôle de la décharge d'une batterie comportant des modules constitués d'au moins un générateur électrochimique qui comprend les étapes suivantes :

(a) on mesure à un instant $t_n$ une tension $Vz(t_n)$ de chaque module z, et un courant de décharge $I(t_n)$,
(b) on calcule le résistance interne $IRz(t_n)$ de chaque module z telle que

$$IRz(t_n) = Vz(t_n)\ /\ I(t_n),$$

(c) on mesure à un instant $t_{n+1}$ une tension $Vz(t_{n+1})$ de chaque module z et un courant de décharge $I(t_{n+1})$,
(d) on calcule la résistance interne $IRz(t_{n+1})$ de chaque modulez telle que

$$IRz(t_{n+1}) = Vz(t_{n+1})\ /\ I(t_{n+1}),$$

(e) on calcule la pente de variation de la résistance interne IRSz de chaque module z entre les instants $t_n$ et $t_{n+1}$ telles que $IRSz = [IRz(t_{n+1}) - IRz(t)]\ /\ I(t_n)$,
(f) on calcule la valeur maximale $IRS^{max}$ et la valeur moyenne $IRS^{moy}$ des pentes de variation de la résistance interne de tous les modules,
(g) on calcule une différence DIRS telle que $DIRS = IRS^{max} - IRS^{moy}$

(h) on compare la différence DIRS à un critère K déterminé expérimentalement,
(i) on arrête la première phase de charge lorsque DIRS est supérieur ou égal K, après correction de la pente dI/dt de variation du courant de décharge I(t) dans le temps.

FIG. 2

**Description**

La présente invention se rapporte à un procédé permettant de contrôler la décharge d'une batterie comprenant au moins deux générateurs électrochimiques, secondaires, et notamment de détecter la fin de la décharge. Ce procédé est plus particulièrement destiné à être appliqué à une batterie de générateurs électrochimiques secondaires, ou accumulateurs, à électrolyte alcalin notamment ceux basés sur le couple nickel-métal hydrurable.

Un accumulateur est dit "industriel" lorsqu'il possède une forte capacité supérieure à 10Ah, et généralement comprise entre 50Ah et 200Ah. Ces accumulateurs ont habituellement un conteneur de forme prismatique en matériau plastique contenant des électrodes planes. Leur géométrie parallélépipédique et la nature de leur bac ne leur permettent pas de résister à des surpressions importantes et leur pression interne maximale est de l'ordre de 1 à 2 bars. Les accumulateurs industriels du type dit "sans maintenance" d'une part et du type dit "étanche" d'autre part, présentent l'avantage de ne pas nécessiter de remise à niveau de l'électrolyte aqueux pendant toute leur durée d'utilisation, contrairement aux accumulateurs industriels du type dit "ouvert classique" ou du type dit "ouvert à maintenance allégée".

Les batteries de tels accumulateurs sont utilisés dans le domaine aéronautique, ferroviaire, routier et stationnaire. Ils sont notamment destinés à la traction de véhicules électriques. Dans cette application, la durée de vie requise est d'environ 1 500 cycles de charge/décharge sur une période estimée à 10 ans. Une durée de vie aussi longue ne peut être atteinte que si on évite toute détérioration prématurée des générateurs. En particulier le déroulement de la décharge doit être strictement contrôlé de manière à éviter toute inversion, ou sur-décharge, de l'un des générateurs.

Pour les batteries d'accumulateurs industriels ouverts classiques nickel-cadmium, la sur-décharge a peu d'influence sur la durée de vie de l'accumulateur car la consommation en eau est compensée périodiquement par des ajouts de maintenance. La gestion de la fin de la décharge s'effectue au travers de la tension totale de la batterie. La décharge est arrêtée lorsque la tension de la batterie atteint une valeur que l'on s'est fixé.

Par ailleurs, il existe une décroissance en puissance vers la fin de décharge. Afin de rendre plus graduelle cette chute de puissance, la méthode consiste à grouper les accumulateurs (par exemple 5 à 10 accumulateurs) et à comparer la tension des groupes entre eux : l'accroissement de cette différence est d'autant plus important que la fin de décharge est proche. La décharge est arrêtée quand la différence de tension $\Delta V$ entre les tensions de deux des groupes d'accumulateur atteint une valeur prescrite.

Un perfectionnement à cette dernière méthode consiste à pondérer la différence de tension $\Delta V$ par la tension moyenne $V^{moy}$ des groupes d'accumulateurs pour obtenir une valeur pondérée $\Delta V/V$ qui est comparé à un critère donné.

Les accumulateurs industriels sans maintenance ou étanche, en particulier nickel-métal hydrurable, sont plus fragiles vis-à-vis de la surdécharge notamment à cause de la génération de gaz, la quantité limitée de l'électrolyte et l'altération des matières actives résultant de l'inversion. Si on applique le même procédé, il faut comparer la tension des modules formés de plusieurs accumulateurs groupés, mais on doit arrêter la décharge lorsque la différence entre la tension des modules atteint un seuil suffisamment faible pour éviter la surdécharge. Cependant il peut arriver que cette valeur de seuil soit atteinte alors que la batterie ne se trouve pas en fin de décharge. Ce phénomène peut être dû à la dispersion de la résistance interne entre les accumulateurs (vieillissement différencié, remplacement d'un accumulateur, ...), à la dispersion de la température au sein d'une batterie, ou encore à la dispersion d'état de charge entre les modules.

La présente invention a pour but de proposer un procédé de contrôle de la première phase de décharge d'une batterie d'accumulateurs entre lesquels existe une dispersion de résistance interne.

L'objet de la présente invention est un procédé de contrôle de la décharge d'une batterie comportant une pluralité de modules, chacun constitué d'au moins un générateur électrochimique secondaire, qui comprend les étapes suivantes :

(a) on mesure de façon synchrone à un instant $t_n$ une tension $V(t_n)$ de chaque module, et un courant de décharge $I(t_n)$,
(b) on calcule une résistance interne $IR(t_n)$ de chaque module telle que

$$IR(t_n) = V(t_n) / I(t_n),$$

(c) on mesure à un instant $t_{n+1}$ une tension $V(t_{n+1})$ de chaque module et un courant de décharge $I(t_{n+1})$,
(d) on calcule une résistance interne $IR(t_{n+1})$ de chaque module telle que

$$IR(t_{n+1}) = V(t_{n+1}) / I(t_{n+1}),$$

(e) on calcule une pente de variation de la résistance interne IRS de chaque module entre les instants $t_n$ et $t_{n+1}$ telle que IRS = [IR $(t_{n+1})$ - IR $(t_n)$] / $(t_{n-+1}-t_n)$,

(f) on calcule une valeur maximale $IRS^{max}$ et une valeur moyenne $IRS^{moy}$ des pentes de variation de la résistance interne de tous les modules,

(g) on calcule une différence DIRS telle que DIRS = $IRS^{max}$ - $IRS^{moy}$

(h) on compare la différence DIRS à un critère K déterminé expérimentalement,

(i) on arrête la première phase de décharge lorsque DIRS, après correction de la pente dl/dt de variation du courant de décharge I(t) dans le temps, est supérieur ou égal à K.

On voit que la fin de la première phase de décharge de la batterie est déterminée par le module ayant la plus forte pente de résistance interne.

Le procédé selon l'invention permet de rendre la fin de la décharge plus progressive en introduisant une deuxième phase de décharge, et d'éviter l'inversion d'un module en fin de décharge malgré la dispersion de résistance interne entre les modules.

Dans le cas particulier où la batterie est composée de deux modules, chacun constitué d'au moins un générateur électrochimique secondaire, le procédé de contrôle de la décharge selon l'invention comprend les étapes suivantes :

(a) on mesure de façon synchrone à un instant $t_n$ une tension $V_1 (t_n)$ pour le module 1, une tension $V_2 (t_n)$ pour le module 2, et un courant de décharge I $(t_n)$,

(b) on calcule une résistance interne $IR_1 (t_n)$ et $IR_2 (t_n)$ de chacun des modules 1 et 2, respectivement telles que $IR_1 (t_n) = V_1 i (t_n) / I (t_n)$ et $IR_2 (t_n) = V_2 (t_n) / I (t_n)$,

(c) on mesure à un instant $t_{n+1}$ une tension $V_1 (t_{n+1})$ pour le module 1, une tension $V_2 (t_{n+1})$ pour le module 2, et un courant de décharge I $(t_{n+1})$,

(d) on calcule des résistances internes $IR_1 (t_{n+1})$ et $IR_2 (t_{n+1})$ de chacun des modules 1 et 2, respectivement telles que $IR_1 (t_{n+1}) = V_1 (t_{n+1}) / I (t_{n+1})$ et

$$IR_2 (t_{n+1}) = V_2 (t_{n+1}) / I (t_{n+1}),$$

(e) on calcule des pentes de variation des résistances internes $IRS_1$ et $IRS_2$ de chacun des modules 1 et 2 entre les instants $t_n$ et $t_{n+1}$ respectivement telles que $IRS_1 = [IR_1 (t_{n+1}) - IR_1 (t_n)] / (t_{n+1} - t_n)$ et $IRS_2 = [IR_2 (t_{n+1}) - IR_2 (t_n)] / (t_{n+1} - t_n)$,

(f) on calcule une différence DIRS entre les pentes des résistances interne des modules 1 et 2 telle que DIRS = $IRS_1$ - $IRS_2$,

(g) on compare la différence DIRS à un critère K déterminé expérimentalement,

(h) on arrête la première phase de charge lorsque DIRS, après correction de la pente dl/dt de la variation dl/dt du courant de décharge I(t) dans le temps, est supérieur ou égal à K.

Cette correction de pente dl/dt de DIRS est rendue nécessaire par l'aspect dynamique du fonctionnement en véhicule électrique qui alterne les phases d'accélération et de décélération durant lesquelles le courant est inversé. On peut envisager différentes lois assurant la correction de la différence DIRS entre les pentes des résistances interne des modules en fonction de la pente dl/dt de la courbe de variation du courant I (t) dans le temps. Selon un mode de réalisation préférentiel, DIRS est une fonction linéaire de la variation dl/dt du courant de décharge I (t) dans le temps.

La deuxième phase de décharge peut être soit un arrêt complet de la charge, soit une réduction progressive du courant de décharge I(t). De préférence le courant de décharge I(t) durant la première phase de décharge est au moins égal à 100A.

La présente invention a en outre comme avantage que le procédé selon l'invention génère des alertes intermédiaires conduisant à une réduction du courant de décharge afin d'autoriser une fin de décharge progressive.

Les notations suivantes seront utilisées dans la description qui va suivre :

I (t) : valeur du courant de décharge de la batterie à l'instant t, exprimée en Ampère ;

Vi(t) : tension d'un module i de la batterie à l'instant t, exprimée en Volt ;

$V^{moy}$ : valeur moyenne des tensions de module, exprimée en Volt ;

$V^{min}$ : valeur de tension de module la plus faible, exprimée en Volt ;

$\Delta V = V^{moy}$ - $V^{min}$ : différence entre la valeur moyenne $V^{moy}$ et la valeur la plus faible $V^{min}$ des tensions de module, exprimée en Volt ;

$\Delta V / V = (V^{moy}$ - $V^{min}) / V^{moy}$ : différence entre la valeur moyenne $V^{moy}$ et la valeur la plus faible $V^{min}$ des tensions de module, pondérée par la tension moyenne $V^{moy}$ des modules constituant la batterie ;

$IRi$ (t) : résistance interne d'un module i à l'instant t, exprimée en Ohm ;

$IRSi$ : pente de variation de la résistance interne du module i, exprimée en Ohm par seconde ;

$IRS^{max}$ : valeur la plus élevée d'une pente de variation de la résistance interne parmi les pentes IRS de chacun des modules constituant la batterie, exprimée en Ohm par seconde ;

$IRS^{moy}$ : valeur moyenne des pentes de variation de la résistance interne de l'ensemble des modules constituant la batterie, exprimée en Ohm par seconde ;

DIRS : différence entre la pente maximale $IRS^{max}$ et la pente moyenne $IRS^{moy}$ des résistances internes des modules constituant la batterie qui dépend de la variation du courant de décharge dans le temps, exprimée en Ohm par seconde ;

K : valeur de comparaison du critère DIRS pour déterminer la fin de la première phase de décharge, c'est une constante déterminée de manière expérimentale exprimée en Ohm par seconde.

On va maintenant donner la description d'exemples de mise en oeuvre de l'invention faite ci-après en référence au dessin annexé dans lequel :

- la figure 1 représente schématiquement le procédé selon l'invention dans le cas où la batterie comporte deux modules 1 et 2 ;
- la figure 2 est analogue à la figure 1 dans le cas où la batterie comporte plus de deux modules ;
- la figure 3 donne l'évolution de la différence DIRS entre les pentes des résistances interne des modules en Ohm par seconde, en fonction du courant I en Ampère ;
- la figure 4 donne l'évolution de la différence DIRS entre les pentes des résistances interne des modules en Ohm par seconde, en fonction de la variation du courant dans le temps dI/dt en Ampère par seconde ;
- la figure 5 montre la variation du courant de décharge I en Ampère au cours du "Dynamic Stress Test" à puissance constante sans limitation du courant, en fonction du temps de décharge t en secondes ;
- la figure 6 représente l'application du critère ΔV à la décharge d'une batterie au cours d'un cyclage électrique dynamique de décharge à courant variable dans le cas où les modules ont peu de différence de résistance interne ; on a porté le critère ΔV en ordonnée à gauche et la tension moyenne $V^{moy}$ en Volts en ordonnée à droite, le temps de décharge t en seconde est donné en abscisse ;
- la figure 7 est analogue à la figure 6 mais en appliquant le critère ΔV/V;
- la figure 8 est analogue à la figure 6 mais en appliquant le critère DIRS selon le procédé de l'invention ;
- la figure 9 représente l'application du critère ΔV à la décharge d'une batterie au cours d'un cyclage électrique dynamique de décharge à courant variable dans le cas où les modules ont une importante différence de résistance interne ; on a porté le critère ΔV en ordonnée à gauche et la tension moyenne $V^{moy}$ en Volts en ordonnée à droite, le temps de décharge t en seconde est donné en abscisse ;
- la figure 10 analogue à la figure 9 mais en appliquant le critère ΔV/V ;
- la figure 11 est analogue à la figure 9 mais en appliquant le critère DIRS selon le procédé de l'invention ;
- la figure 12 montre la variation du courant en fonction du temps lors d'une décharge représentative du fonctionnement en véhicule électrique ;
- la figure 13 représente l'application du critère ΔV à la décharge d'une batterie au cours d'une décharge à courant variable représentative du fonctionnement en véhicule électrique dans le cas où les modules ont une différence de résistance interne ; on a porté le critère ΔV en ordonnée à gauche et la tension $V^{moy}$ de la batterie en Volts en ordonnée à droite, le temps de décharge t en seconde est donné en abscisse ;
- la figure 14 est analogue à la figure 13 mais en appliquant le critère ΔV/V;
- la figure 15 est analogue à la figure 13 mais en appliquant le critère DIRS selon le procédé de l'invention.

Il doit être bien entendu toutefois que ces exemples de mise en oeuvre sont donnés uniquement à titre d'illustration de l'objet de l'invention dont ils ne constituent en aucune manière une limitation.

EXEMPLE 1

Une batterie A est composée de 28 modules monoblocs de 12V-93Ah, raccordés électriquement en série, constitués chacun de 10 accumulateurs nickel-métal hydrurable raccordés électriquement en série. La différence de résistance interne entre les modules est inférieure à 2,4mΩ.

Bien entendu, on peut modifier le nombre de générateurs électrochimiques constituant un module et le nombre de modules que comporte la batterie.

Cette batterie A est soumise à un cyclage électrique dynamique de décharge à courant variable (DST : Dynamic Stress Test) selon la norme SAE (Society of Automotive Engineers) référence J1798 intitulée "Recommanded Practice for Performance Rating of Electric Véhicule Battery Modules". L'ensemble de cet algorithme est programmé sur des systèmes de bancs de test DIGATRON géré par leur système BTS 600.

Les conditions de cyclage sont les suivantes :

- décharge de 80% de la capacité nominale, soit 74.4Ah par module, pendant laquelle le liquide de refroidissement circule dans la batterie mais il n'y a pas de refroidissement actif ;
- charge à lc/3 suivie d'une surcharge à lc/20 de 4.4Ah pour le nivellement des états de charge, où lc est le courant nécessaire théorique pour décharger la batterie en une heure. Pendant la charge, le refroidissement est actif à 12°C.

Le test, qui veut être représentatif d'un fonctionnement réel, est construit avec des successions de périodes de charge et de décharge alternant toutes les 6mn, c'est ce qui produit cet effet de pulsation. Le procédé selon l'invention est plus particulièrement destiné à être utilisé dans des conditions dynamiques dans lesquelles le sens et la valeur du courant changent fréquemment.

La fin de charge est déterminée par un critère lié à l'évolution de la température dans le temps dT/dt, qui s'applique au premier module qui l'atteint. La fin de la décharge est contrôlée par les procédés de l'art antérieur utilisant le critère $\Delta V$ et le critère $\Delta V/V$ et par le critère DIRS selon le procédé de la présente invention.

Critère $\Delta V$ :

A chaque instant t la tension $V_i$ (t) de chaque module i est mesurée, avec i = 1 à 28 dans le cas présent. Puis une tension moyenne $V^{moy}$ est calculée à partir de ces 28 valeurs. On peut alors calculer la différence $\Delta V = V^{moy} - V^{min}$ où $V^{min}$ est la plus faible des tensions $V_i$ mesurée pour un module, et on arrête la décharge lorsque $\Delta V = 0,7$ Volt.

Critère $\Delta V/V$ :

Comme précédemment, on mesure à chaque instant t la tension $V_i$ (t) de chaque module i (i = 1 à 28). Puis une tension moyenne $V^{moy}$ est calculée à partir de ces valeurs. On peut alors calculer le critère $\Delta V/V = (V^{moy} - V^{min})$ / $V^{moy}$ où $V^{min}$ est la plus faible des tensions $V_i$ mesurée pour un module i, et on arrête la décharge pour $\Delta V/V = 0,1$.

En début de décharge, la tension $V_i$ de chaque module est élevée ($V^{moy}$ est de l'ordre de 12V). Le critère $\Delta V/V$ = 0.1 permet de tolérer une différence de tension entre les modules qui peut atteindre 1.2V, donc une grande différence de résistance interne entre les modules.

Ce critère offre une plus grande tolérance vis à vis de la plus grande partie de la décharge. Le but est de détecter en fin de décharge l'inversion possible d'un accumulateur au sein d'un module. A la fin de la décharge, la tension des modules est faible (par exemple $V_i$ = 8V pour un module i de 10 accumulateurs). Dans ce cas une différence de tension de 0.8V correspond à $\Delta V/V$ = 0.1.

Procédé selon l'invention :

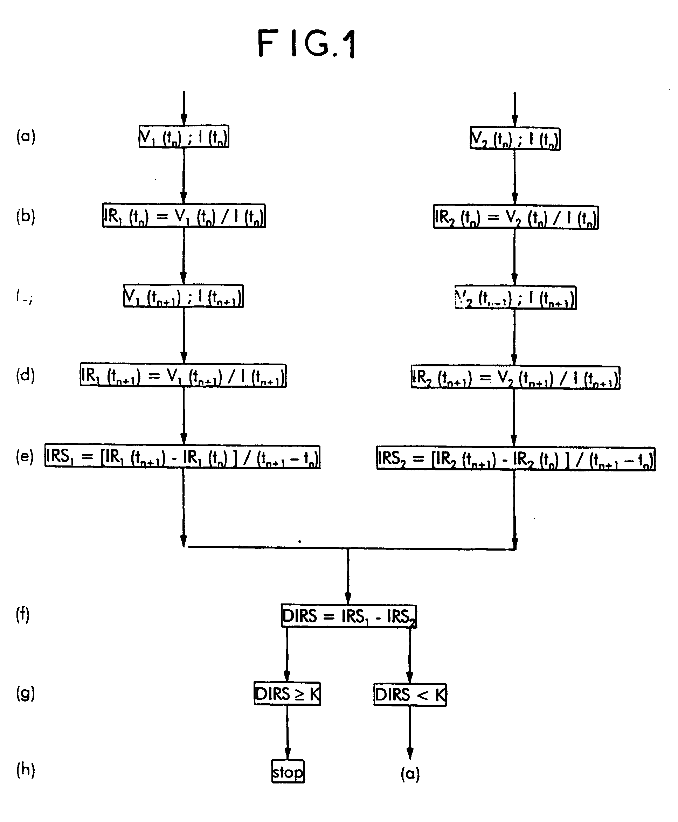

Le procédé est représentée sur la figure 1 dans le cas particulier où la batterie comporte deux modules 1 et 2. Bien entendu le procédé s'applique tout aussi bien à une batterie comportant un nombre supérieur de modules.

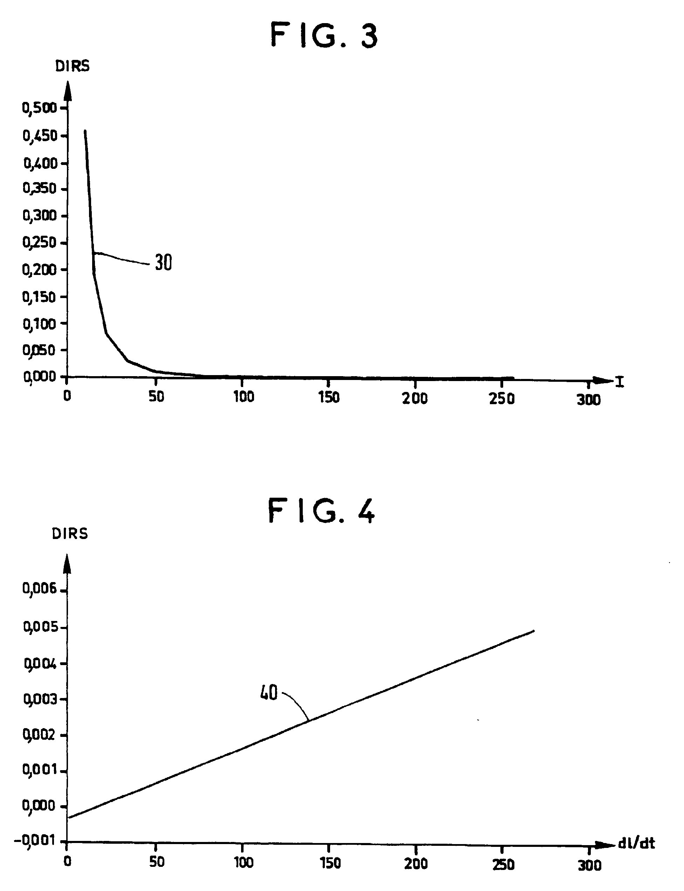

Périodiquement, on mesure de manière synchrone (c'est à dire dans un intervalle de temps inférieur à 10 millisecondes) la tension $V_{i=1\,à\,28}(t)$ de chacun des modules et le courant de décharge I(t) de la batterie. Pour que le procédé selon l'invention soit plus facilement applicable, il est préférable que le courant de décharge soit au moins égal à 100A comme le montre la courbe 30 de la figure 3 qui représente l'évolution du critère DIRS en fonction du courant I(t). La courbe 40 de la figure 4 montre que le critère DIRS varie linéairement avec la pente de variation du courant de décharge dans le temps dl/dt.

Comme le montre la figure 1, on mesure au cours de la première étape (a) la tension $V_1$ ($t_n$) du module 1, la tension $V_2$ ($t_n$) du module 2, et le courant de décharge I ($t_n$) de la batterie un instant $t_n$. Puis dans l'étape (b) on calcule les résistances internes des modules 1 et 2, respectivement $IR_1$ ($t_n$) = $V_1$ ($t_n$) / I ($t_n$) et $IR_2$ ($t_n$) = $V_2$ ($t_n$) / I ($t_n$).

A l'instant suivant $t_{n+1}$, on mesure de la même manière les tensions $V_1$ ($t_{n+1}$) et $V_2$ ($t_{n+1}$) des modules 1 et 2, ainsi que le courant de décharge I ($t_{n+1}$) de la batterie (étape (c)). Et on calcule les résistances internes des modules 1 et 2, respectivement $IR_1$ ($t_{n+1}$) = $V_1$ ($t_{n+1}$) / I ($t_{n+1}$) et $IR_2$ ($t_{n+1}$) = $V_2$ ($t_{n+1}$) / I ($t_{n+1}$) dans l'étape (d).

Ensuite on calcule les pentes des résistances internes des modules 1 et 2 entre les instants $t_n$ et $t_{n+1}$ au cours de l'étape (e) qui sont respectivement $IRS_1$ = [$IR_1$ ($t_{n+1}$) - $IR_1$ ($t_n$)]/($t_{n+1}$ - $t_n$) et $IRS_2$ = [$IR_2$ ($t_{n+1}$) - $IR_2$ ($t_n$)]/($t_{n+1}$ - $t_n$).

Enfin on calcule dans l'étape (f) la différence DIRS entre les pentes des résistances internes des modules 1 et 2 qui vaut DIRS = $IRS_1$ - $IRS_2$. Pour décider si la décharge doit être arrêtée ou si on doit diminuer le courant pour obtenir une fin de décharge progressive, à l'étape (g) on compare la différence de pente DIRS à un critère K et on arrête la première phase de la décharge si la différence DIRS est supérieure ou égale au critère K.

Le critère K est une valeur en Ohms/s déterminée expérimentalement. Avant comparaison, la différence de pente DIRS doit être corrigée en fonction de la variation dI/dt du courant de décharge I(t) comme représenté sur la courbe 40 de la figure 4 (phase d'accélération ou de décélération) pour être ramenée à une valeur correspondant aux conditions dans lesquels K a été déterminé. Bien entendu la correction pourrait tout aussi bien être appliquée à K au lieu de DIRS.

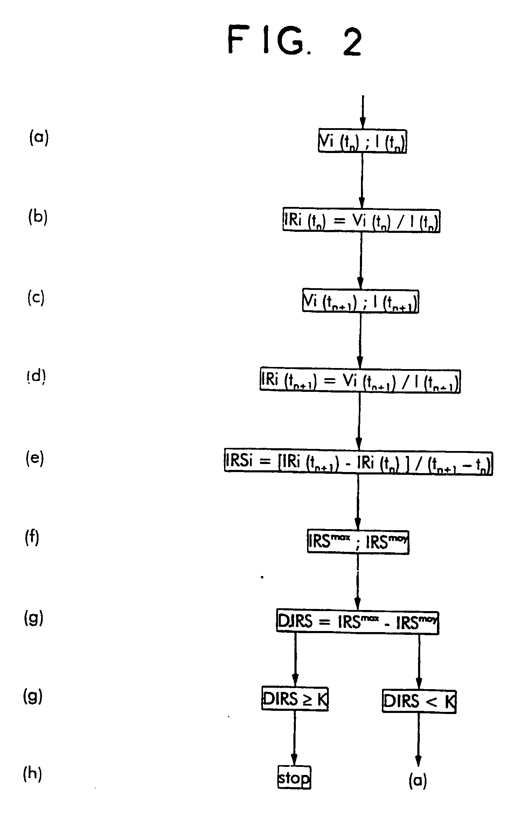

Comme le montre la figure 2 dans le cas d'une batterie comportant un plus grand nombre de modules, on calcule comme précédemment les pentes IRSi des résistances internes IRi de chacun des modules i constituant la batterie entre les instants $t_n$ et $t_{n+1}$ : $IRS_i = V_i (t_{n+1})/I(t_{n+1}) - V_i (t_n) / I(t_n)$. Puis on calcule la valeur maximale $IRS^{max}$ et la valeur moyenne $IRS^{moy}$ des pentes de résistance interne de l'ensemble des modules constituant la batterie. Le paramètre DIRS qui détermine la fin de décharge de la batterie est la différence entre la pente maximale de résistance interne $IRS^{max}$ et la pente moyenne $IRS^{moy}$ : $DIRS = IRS^{max} - IRS^{moy}$. La valeur de ce paramètre DIRS, corrigé de la variation du courant I(t) dans le temps, est comparée au critère K pour décider de l'arrêt de la décharge ou de la limitation du courant. La première phase de la décharge se termine lorsque DIRS est égal ou supérieur à K. On voit ainsi que la fin de la première phase de la décharge de la batterie est provoquée par le module ayant la plus forte pente de résistance interne.

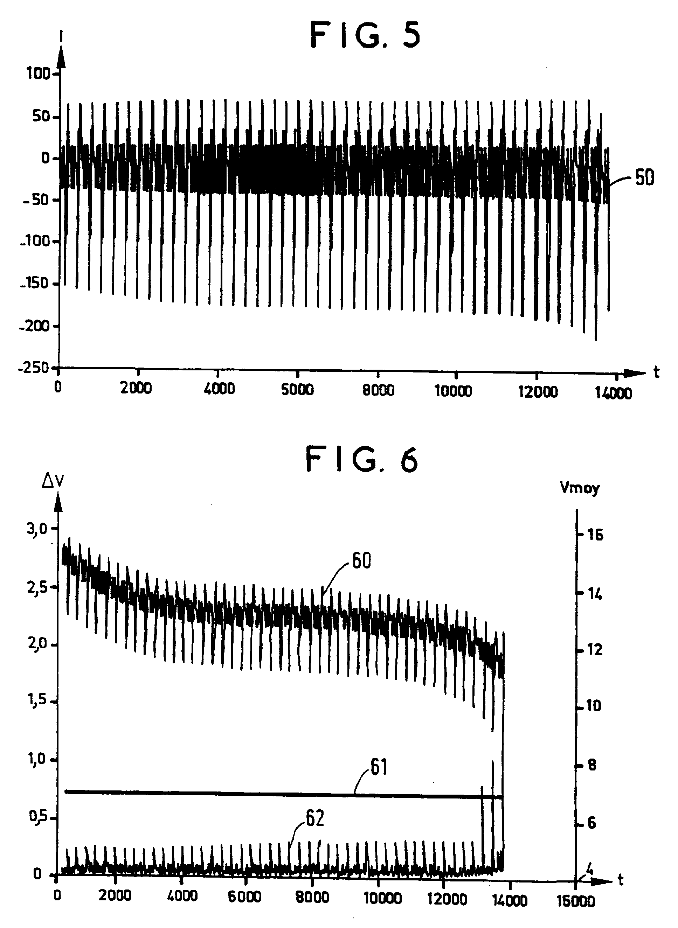

La courbe 50 de la figure 5 représente la variation du courant I en ampères en fonction du temps t de décharge en secondes. Les figures 6, 7 et 8 illustrent respectivement l'application à la batterie A des critères ΔV et ΔV/V de l'art antérieur et du critère DIRS du procédé selon l'invention au cours du DST. La valeur du critère appliqué est représentée sur les figures par une ligne horizontale.

Sur la figure 6, la courbe 60 représente la variation de la tension $V^{moy}$ des modules, qui représente la tension de la batterie, et la courbe 61 montre l'évolution du critère ΔV en fonction du temps de décharge t. La valeur de référence 62 fixée pour le critère ΔV est indiquée égale à 0,7V.

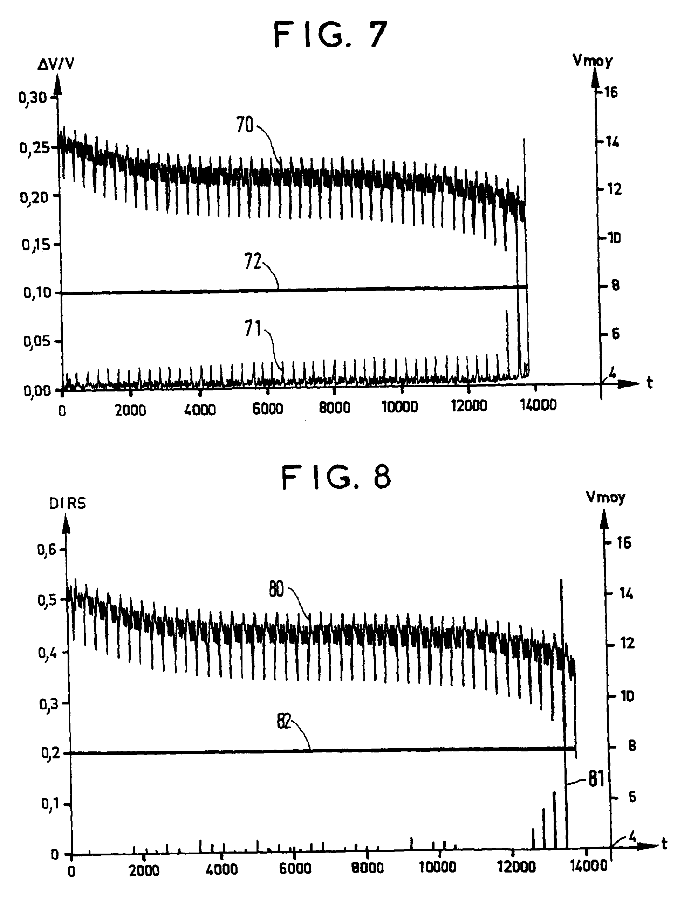

Sur la figure 7, la courbe 70 représente la variation de la tension $V^{moy}$ des modules et la courbe 71 montre l'évolution du critère ΔV/V en fonction du temps de décharge t. La valeur de référence 72 du critère ΔV/V est ici indiquée égale à 0,1.

Sur la figure 8, la courbe 80 représente la variation de la tension $V^{moy}$ des modules et la courbe 81 montre l'évolution du critère DIRS en fonction du temps de décharge t. La valeur de référence K est ici indiquée égale à 0,2mΩ/s.

En comparant ces trois figures représentant le cas où les modules ont peu de différence de résistance interne, on constate que les trois méthodes permettent de détecter la survenue de l'inversion d'un groupe d'accumulateurs après environ 13 900s de décharge. Si la différence de résistance interne entre les modules est faible, les trois méthodes ont une efficacité comparable.

EXEMPLE 2

Une batterie B, analogue à la batterie A, mais présentant une différence de résistance interne entre les modules plus importante que dans la batterie A, de l'ordre de 10mΩ, est soumise à un cyclage électrique dans les même conditions de fonctionnement que dans l'exemple 1.

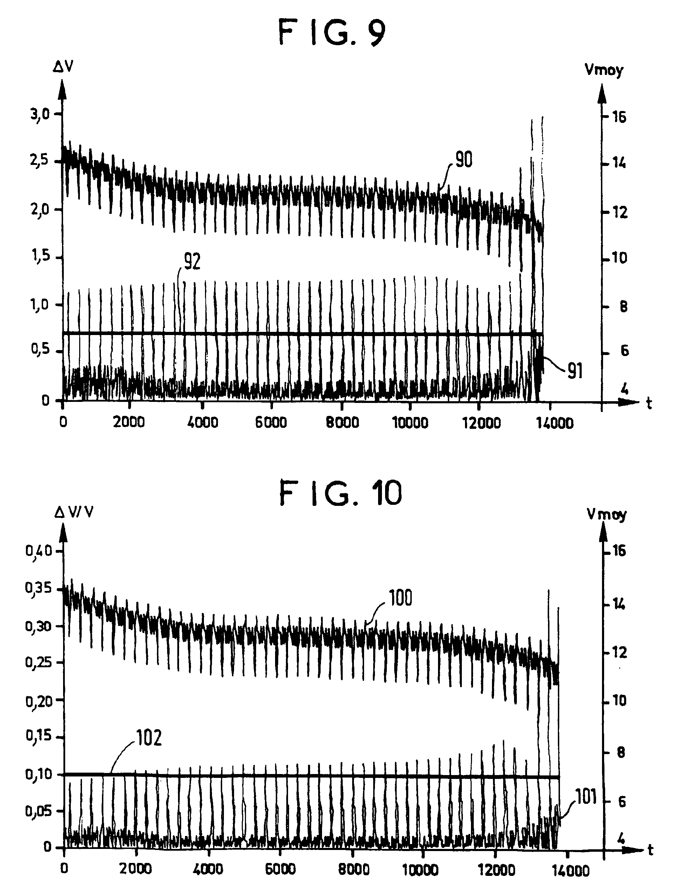

Les figures 9, 10 et 11 illustrent respectivement l'application à la batterie B des critères ΔV et ΔV/V de l'art antérieur et du critère DIRS du procédé selon l'invention, au cours du DST. La valeur du critère appliqué est représentée sur la figure par une ligne horizontale.

Sur la figure 9, la courbe 90 représente la variation de la tension $V^{moy}$ des modules et la courbe 91 montre l'évolution du critère ΔV en fonction du temps de décharge t. La valeur de référence 92 du critère ΔV est ici indiquée égale à 0,7V.

Sur la figure 10, la courbe 100 représente la variation de tension $V^{moy}$ des modules et la courbe 101 montre l'évolution du critère ΔV/V en fonction du temps de décharge t. La valeur de référence 102 du critère ΔV/V est ici indiquée égale à 0,1.

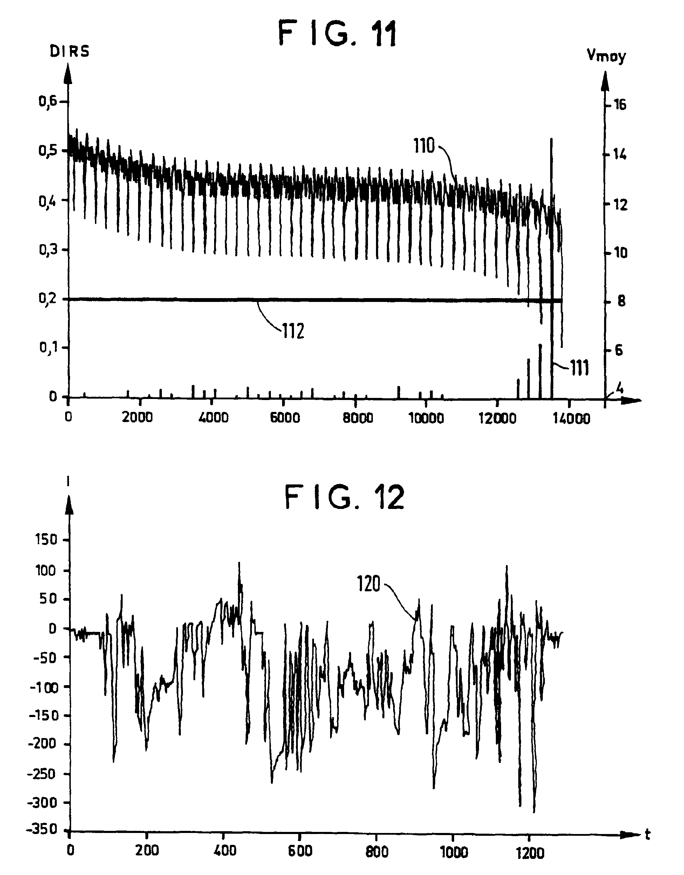

Sur la figure 11, la courbe 110 représente la variation de tension $V^{moy}$ des modules et la courbe 111 montre l'évolution du critère DIRS en fonction du temps de décharge t. La valeur de référence K est ici indiquée égale à 0,2mΩ/s.

On observe dans ce cas que l'application du critère ΔV arrête la décharge après environ 210s à cause de la différence de résistance interne entre les modules, alors que l'application du critère ΔV/V permet d'atteindre 1400s. Mais en appliquant le procédé selon la présente invention, la décharge s'interrompt après 13500s, ce qui permet d'atteindre la pleine décharge de la batterie. Ceci montre bien un meilleur contrôle de la fin de la décharge par le procédé selon l'invention malgré la différence de résistance interne entre les modules.

EXEMPLE 3

Une batterie C est composée de 28 modules monoblocs 12V-93Ah raccordés électriquement en série, constitués chacun de 10 accumulateurs nickel-métal hydrurable raccordés électriquement en série. Les modules possèdent des résistances internes très différentes, qui peuvent atteindre un écart de 3mΩ.

La batterie C est soumise à un cyclage électrique dans les mêmes conditions de fonctionnement que dans un véhicule électrique, les variations du courant étant notamment aléatoires. La courbe 120 de la figure 12 montre la variation aléatoires du courant I dans le temps t lors d'une décharge en véhicule électrique.

Les conditions de cyclage sont les suivantes :

- charge à lc/3 jusqu'à ce qu'un premier module atteigne le critère dT/dt, suivi d'une surcharge de 1Ah à 6Ah à un courant 4,5A selon la profondeur de la décharge précédente, avec un refroidissement actif à 12°C durant toute la charge,
- décharge à un régime et une profondeur de décharge variable, le refroidissement devenant actif à 12°C lorsque la température des modules dépasse 40°C.

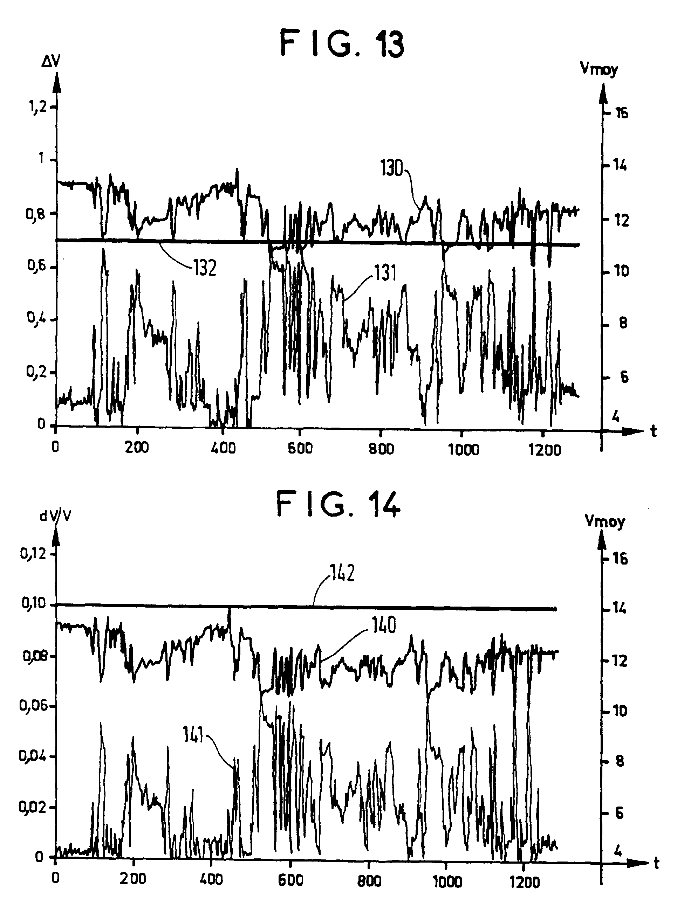

Les figures 13, 14 et 15 illustrent respectivement l'application à la batterie C des critères $\Delta V$ et $\Delta V/V$, et du critère DIRS selon le procédé de l'invention, au cours d'un test représentatif d'un fonctionnement réel. La valeur du critère appliqué est représentée sur la figure par une ligne horizontale.

Sur la figure 13, la courbe 130 représente la variation de tension $V^{moy}$ des modules et la courbe 131 montre l'évolution du critère $\Delta V$ en fonction du temps de décharge t. La valeur de référence 132 du critère $\Delta V$ est ici indiquée égale à 0,7V.

Sur la figure 14, la courbe 140 représente la variation de tension $V^{moy}$ des modules et la courbe 141 montre l'évolution du critère $\Delta V/V$ en fonction du temps de décharge t. La valeur de référence 142 du critère $\Delta V/V$ est ici indiquée égale à 0,1.

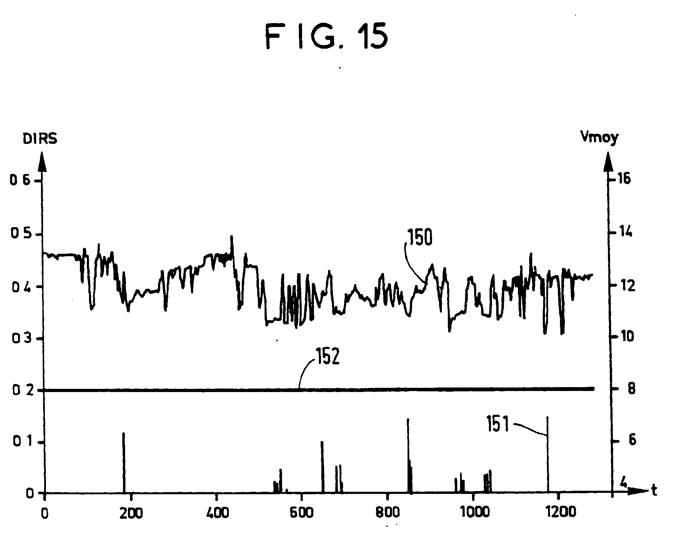

Sur la figure 15, la courbe 150 représente la variation de tension $V^{moy}$ des modules et la courbe 151 montre l'évolution du critère DIRS en fonction du temps de décharge t. La valeur de référence K est ici indiquée égale à 0,2mΩ/s.

On observe que dans ce cas que l'application du critère $\Delta V$ arrête la décharge de manière prématurée après environ 550s de décharge à cause de la différence de résistance interne entre les modules. En appliquant le critère $\Delta V/V$ ou le procédé selon la présente invention, la décharge peut se poursuivre au-delà de 1300s sans interruption. En conditions plus proches de l'utilisation réelle de la batterie, il est clair que l'application du critère $\Delta V$ ne permet pas de décharger la batterie C de manière satisfaisante. La supériorité du procédé selon l'invention est évidente dans ces conditions.

**Revendications**

1. Procédé de contrôle de la décharge d'une batterie comportant une pluralité de modules, chacun constitué d'au moins un générateur électrochimique secondaire, qui comprend les étapes suivantes :

(a) on mesure de façon synchrone à un instant $t_n$ une tension $Vz (t_n)$ de chaque module z, et un courant de décharge $I (t_n)$,
(b) on calcule le résistance interne $IRz (t_n)$ de chaque module z telle que

$$IRz (t_n) = Vz (t_n) / I (t_n),$$

(c) on mesure à un instant $t_{n+1}$ une tension $Vz (t_{n+1})$ de chaque modulez et un courant de décharge $I (t_{n+1})$,
(d) on calcule la résistance interne $IRz (t_{n+1})$ de chaque modulez telle que

$$IRz (t_{n+1}) = Vz(t_{n+1})/I(t_{n+1}),$$

(e) on calcule la pente de variation de la résistance interne $IRSz$ de chaque module z entre les instants $t_n$ et $t_{n+1}$ telles que $IRSz = [IRz (t_{n+1}) - IRz (t)] / I(t_n)$,
(f) on calcule la valeur maximale $IRS^{max}$ et la valeur moyenne $IRS^{moy}$ des pentes de variation de la résistance interne de tous les modules,

(g) on calcule une différence DIRS telle que DIRS = $IRS^{max}$ - $IRS^{moy}$

(h) on compare la différence DIRS à un critère K déterminé expérimentalement,

(i) on arrête la première phase de charge lorsque DIRS est supérieur ou égal K, après correction de la pente dI/dt de variation du courant de décharge I(t) dans le temps.

**2.** Procédé de contrôle de la décharge d'une batterie composée de deux modules, chacun constitué d'au moins un générateur électrochimique secondaire, qui comprend les étapes suivantes :

(a) on mesure de façon synchrone à un instant $t_n$ une tension $V_1$ (tn) pour le module 1, une tension $V_2$ ($t_n$) pour le module 2, et un courant de décharge I ($t_n$),

(b) on calcule des résistances internes $IR_1$ ($t_n$) et $IR_2$ ($t_n$) telles que

$$IR_1 (t_n) = V_1 i (t_n) / I (t_n) \text{ et } IR_2 (t_n) = V_2 (t_n) / I (t_n).$$

(c) on mesure à un instant $t_{n+1}$ une tension $V_1$ ($t_{n+1}$) pour le module 1, une tension $V_2$ ($t_{n+1}$) pour le module 2, et un courant de décharge I ($t_{n+1}$),

(d) on calcule des résistances internes $IR_1$ ($t_{n+1}$) et $IR_2$ ($t_{n+1}$) telles que

$$IR_1 (t_{n+1}) = V_1 (t_{n+1}) / I (t_{n+1}) \text{ et } IR_2 (t_{n+1}) = V_2 (t_{n+1}) / I (t_{n+1}),$$

(e) on calcule des pentes de variation des résistances internes $IRS_1$ et $IRS_2$ entre les instants $t_n$ et $t_{n+1}$ telles que $IRS_1 = [IR_1 (t_{n+1}) - IR_1 (t_n)] / (t_{n+1} - t_n)$ et

$$IRS_2 = [IR_2 (t_{n+1}) - IR_2 (t_n)] / (t_{n+1} - t_n),$$

(f) on calcule une différence DIRS entre les pentes des résistances interne des modules 1 et 2 telle que DIRS = $IRS_1$ - $IRS_2$,

(g) on compare la différence DIRS à un critère K déterminé expérimentalement,

(h) on arrête la première phase de charge lorsque DIRS est supérieur ou égal à K, après correction de la pente dI/dt de la variation dI/dt du courant de décharge I(t) dans le temps,

**3.** Procédé selon l'une des revendications 1 et 2, dans lequel le courant de décharge I(t) est au moins égal à 100A.

**4.** Procédé selon l'une des revendications 1 et 2, dans lequel le critère K est une fonction linéaire de la variation dI/dt du courant de décharge 1 (t) dans le temps.

**5.** Procédé selon l'une des revendications précédentes, dans lequel ledit module est constitué d'au moins deux générateurs raccordés électriquement en série.

# F I G.1

(a) $V_1 (t_n) ; I (t_n)$   $V_2 (t_n) ; I (t_n)$

(b) $IR_1 (t_n) = V_1 (t_n) / I (t_n)$   $IR_2 (t_n) = V_2 (t_n) / I (t_n)$

(c) $V_1 (t_{n+1}) ; I (t_{n+1})$   $V_2 (t_{n+1}) ; I (t_{n+1})$

(d) $IR_1 (t_{n+1}) = V_1 (t_{n+1}) / I (t_{n+1})$   $IR_2 (t_{n+1}) = V_2 (t_{n+1}) / I (t_{n+1})$

(e) $IRS_1 = [IR_1 (t_{n+1}) - IR_1 (t_n) ] / (t_{n+1} - t_n)$   $IRS_2 = [IR_2 (t_{n+1}) - IR_2 (t_n) ] / (t_{n+1} - t_n)$

(f) $DIRS = IRS_1 - IRS_2$

(g) $DIRS \geq K$   $DIRS < K$

(h) stop   (a)

# FIG. 2

(a)     $V_i (t_n) ; I (t_n)$

(b)     $IR_i (t_n) = V_i (t_n) / I (t_n)$

(c)     $V_i (t_{n+1}) ; I (t_{n+1})$

(d)     $IR_i (t_{n+1}) = V_i (t_{n+1}) / I (t_{n+1})$

(e)     $IRS_i = [IR_i (t_{n+1}) - IR_i (t_n) ] / (t_{n+1} - t_n)$

(f)     $IRS^{max} ; IRS^{moy}$

(g)     $DJRS = IRS^{max} - IRS^{moy}$

(g)     $DIRS \geq K$        $DIRS < K$

(h)     stop        (a)

# F IG. 3

# F IG. 4

# FIG. 5

# FIG. 6

# FIG. 7

# FIG. 8

# F IG. 9

# F IG. 10

# F I G. 11

# F I G. 12

# FIG. 13

# FIG. 14

# F IG. 15

EP 1 243 935 A1

## Office européen des brevets

## RAPPORT DE RECHERCHE EUROPEENNE

Numéro de la demande

EP 02 29 0298

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 5 936 383 A (NG PATRICK KWOK-YEUNG ET AL) 10 août 1999 (1999-08-10) * revendications 1,14,19 * | 1,2,5 | G01R31/36 |

| | DOMAINES TECHNIQUES RECHERCHES (Int.Cl.7) |
|---|---|
| | G01R |

Le présent rapport a été établi pour toutes les revendications

| Lieu de la recherche | Date d'achèvement de la recherche | Examinateur |
|---|---|---|
| LA HAYE | 20 mars 2002 | Six, G |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03 82 (P04C02)

18

**ANNEXE AU RAPPORT DE RECHERCHE EUROPEENNE
RELATIF A LA DEMANDE DE BREVET EUROPEEN NO.**

EP 02 29 0298

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-03-2002

| Document brevet cité au rapport de recherche | Date de publication | Membre(s) de la famille de brevet(s) | Date de publication |
|---|---|---|---|
| US 5936383          A | 10-08-1999 | AUCUN | |